# EUROPÄISCHE PATENTSCHRIFT

(11) **EP 2 331 980 B1**
(45) Veröffentlichungstag und Bekanntmachung des Hinweises auf die Patenterteilung: **14.12.2016**
(21) Anmeldenummer: 09783804.9
(22) Anmeldetag: 07.10.2009
(51) Int. Cl.: G01R 31/02, G01R 31/34

(54) **VERFAHREN UND VORRICHTUNG ZUR DETEKTION VON KURZSCHLÜSSEN IM STATOR-BLECHPAKET VON ELEKTROMASCHINEN**
METHOD AND DEVICE FOR DETECTING SHORT-CIRCUITS IN THE STATOR CORE OF ELECTRIC MACHINES
PROCÉDÉ ET DISPOSITIF DE DÉTECTION DE COURTS-CIRCUITS DANS DES MACHINES ÉLECTRIQUES, DANS UN EMPILAGE DE TÔLES D'UN STATOR

(30) Priorität: 08.10.2008 CH 16012008
(43) Veröffentlichungstag der Anmeldung: 15.06.2011
(73) Patentinhaber: General Electric Technology GmbH, 5400 Baden (CH)
(72) Erfinder: HOBELSBERGER, Max, CH-5303 Würenlingen (CH); POSEDEL, Zlatimir, CH-5432 Neuenhof (CH)
(74) Vertreter: General Electric Technology GmbH
(86) Internationale Anmeldenummer: PCT/EP2009/063009
(87) Internationale Veröffentlichungsnummer: WO 2010/040767

(56) Entgegenhaltungen:
- EP-B- 0 344 558
- WO-A-01/81934
- WO-A-03/036287
- DE-A1-102004 056 097
- GB-A- 2 044 936
- US-A- 5 907 244
- US-A1- 2004 000 923
- US-A1- 2004 124 833

## Beschreibung

### TECHNISCHES GEBIET

Die vorliegende Erfindung betrifft eine Vorrichtung und ein Verfahren zur Detektion von Windungsschlüssen im Blechpaket eines Stators einer elektrischen Maschine oder eines Generators. Dabei wird mittels einer Hilfsspule und eines Hilfsstromes der Stator für die Messung magnetisiert und mit einer Aufnahmevorrichtung das magnetische Feld ausgemessen. Die Erfindung bezieht sich also auf ein Verfahren und eine Vorrichtung für die Detektion von interlaminaren Kurzschlüssen im Blechpaket des Stators von Elektromaschinen, insbesondere von grossen Generatoren.

### STAND DER TECHNIK

Grosse Generatoren und Motoren werden routinemässig im Stillstand auf Blechschlüsse hin untersucht. Dazu stehen verschiedene Methoden zur Verfügung.

Eine dieser Methoden umfasst die Magnetisierung des ganzen Blechkörpers mittels einer Hilfsspule bei Netzfrequenz und die Messung von Streufeldern auf der inneren Oberfläche der Stator-Bohrung. Die Magnetisierung erfolgt auf relativ niedrige Werte der magnetischen Induktion, typischerweise auf etwa 10% der normalen Betriebsinduktion. Diese Messmethode ist auch unter dem Namen "Niederinduktions - Blechschlussmessung" bekannt, im englischen Sprachraum unter dem Namen "ELCID". Eine solche Vorrichtung ist z.B. in der US 4,996,486 beschrieben. Die vorliegende Erfindung bezieht sich auf eine Verbesserung dieser Niederinduktions - Messmethode. Eine ähnliche Vorrichtung beschreibt die WO03/036287, wobei hier Phaseninformation und Amplitudeninformation kombiniert ausgewertet werden.

Aus der US 2004/124833 ist des weiteren eine Vorrichtung bekannt, bei welcher der Statorkern über ein Paar von axial nebeneinander angeordneten Eisenkernjochen magnetisiert wird und Messspulen an den benachbarten Jochen dazu eingesetzt werden, das entlang der axialen Richtung differenzielle Verhalten auszumessen.

Stand der Technik ist es also, z.B. das Stator-Blechpaket mittels einer Hilfsspule und eines Hilfsstromes mit Netzfrequenz auf etwa ein Zehntel der Betriebsinduktion zu magnetisieren.

Mit einer elektrischen Aufnahmespule wird dann die Oberfläche der Stator - Bohrung abgefahren, wobei sich die Aufnahmespule nahe der Oberfläche des Blechpakets befindet.

Die Ströme, die mit interlaminaren Kurzschlüssen des Blechpakets verbunden sind, induzieren nun in der Aufnahmespule Spannungen mit charakteristischer Phasen- und Amplitudenlage. Aufgrund dieser charakteristischen Phasen- und Amplitudenlage können Orte mit Blechschluss-Strömen von Orten ohne Blechschluss - Strömen unterschieden werden. Es ist somit möglich, mittels dieser Streufeld - Aufnahmespule Blechschlüsse zu lokalisieren und die Grösse der Kurzschlussströme zu beurteilen.

Nachteilig bei diesem Verfahren ist, dass die Interpretation der Messergebnisse manchmal schwierig ist, da die von den Blechschlussströmen induzierten Spannungen meist sehr klein sind. Insbesondere können starke Streufelder des Stator-Hauptfeldes oder auch verlustbehaftete Zusatzfelder, die z.B. durch in kurzgeschlossenen Leiterschleifen induzierte Ströme zustande kommen, die Wirkung des eigentlichen Kurzschlussstromes durch die Fehlerstelle überdecken und so eine Detektion erschweren. Dies ist besonders bei kleinen Blech - Fehlern der Fall, die nur kleine Ströme führen und nur eine kleine magnetische Wirkung haben. Störende Zusatzfelder treten besonders bei der Prüfung von Hydrogeneratoren auf, wenn zur Prüfung der Rotor nicht entfernt wurde, sodass die Einzelpole eine magnetische Wirkung ausüben.

### DARSTELLUNG DER ERFINDUNG

Der Erfindung liegt demnach die Aufgabe zugrunde, das eingangs beschriebene Verfahren zu verbessern, respektive eine verbesserte Vorrichtung zur Durchführung eines solchen Verfahrens vorzuschlagen. Insbesondere geht es also um eine Verbesserung einer Vorrichtung respektive eines Verfahrens zur Detektion von Windungsschlüssen im Blechpaket eines Stators einer elektrischen Maschine oder eines Generators, wobei mittels einer Hilfsspule und eines Hilfsstromes der Stator magnetisiert und mit einer Aufnahmevorrichtung das magnetische Feld ausgemessen wird. Dabei umfasst die Aufnahmevorrichtung wenigstens zwei Detektoren, welche an zwei verschiedenen radialen Positionen bezüglich der Rotorachse angeordnet sind, und gleichzeitig das magnetische Feld an diesen zwei verschiedenen radialen Positionen messen, wobei die zwei an diesen verschiedenen Orten gemessenen Signale in Grösse und/oder Phasenlage zur Detektion von Windungsschlüssen ausgewertet und miteinander verglichen werden.

Die Lösung dieser Aufgabe wird durch die Merkmale von Anspruch 1 erreicht, das heisst dadurch, dass die relative Grösse und/oder die relative Phasenlage der wenigstens zwei Signale über eine Differenzbildung ermittelt wird, und nur relative Unterschiede in den Signalen aufgezeichnet werden.

Der Kern der Erfindung besteht somit darin, durch die Differenzbildung der beiden Signale gewissermassen auf eine Absolutmessung zu verzichten und nur relative Unterschiede in den Signalen aufzuzeichnen. Die beiden Detektoren, normalerweise Spulen, sind dabei ganz gezielt in der Regel elektrisch nicht voneinander getrennt. So können störende Zusatzfelder gewissermassen ausgeblendet werden und die Diagnose wird so wesentlich vereinfacht. Im Gegensatz zum stand der Technik, wo es immer nur darum geht, die radiale Lokalisierung von Kurzschlüssen durch die vorgeschlagene Vorrichtung vorzunehmen (das heißt man weiß bereits wo ein Kurzschluss ist, dies wurde mit einem anderen Verfahren ermittelt, und ermittelt anschließend dessen Tiefe), erlaubt es das vorgeschlagene Verfahren respektive die vorgeschlagene Vorrichtung, das Verfahren zur Identifikation von Kurzschlüssen zu verwenden (das heißt zur Beantwortung der Frage, wo sind überhaupt Kurzschlüsse) und nicht nur, wenn ein Kurzschluss bereits identifiziert und lokalisiert ist, um dessen radiale Position in einem zweiten Schritt zu ermitteln. Da das herkömmliche Verfahren keine direkte Differenzbildung vornimmt und entsprechend keine Kompensation erlaubt, ist es für die großflächige Identifikation/Lokalisation von Kurzschlüssen nicht geeignet, sondern nur dafür, wenn man die fehlerhafte Stelle bereits kennt, an dieser fehlerhaften Stelle die Tiefe des Fehlers im Blechpaket zu ermitteln. Insbesondere im Bereich der HydroGeneratoren, wo große magnetische Streufelder vorhanden sind, erlauben die Verfahren nach dem Stand der Technik nur schwierig die Ermittlung der Tiefe und auf keinen Fall die Identifikation/Lokalisierung von Fehlstellen, dies ist hingegen mit dem vorgeschlagenen Verfahren gut möglich. Insbesondere dann, wenn eine Vielzahl von Sensoren miniaturisiert in Kombination mit Vorverstärkern/Operationverstärkern direkt im Sensorkopf angeordnet werden. Bevorzugtermassen sind dabei die wenigstens zwei Detektoren im wesentlichen in radialer Richtung bezüglich der Rotorachse übereinander angeordnet. Weiterhin bevorzugt handelt es sich bei den Detektoren um elektrische Spulen, welche so ausgerichtet sind, dass sie primär die bezüglich der zylindrischen inneren Oberfläche der Stator-Bohrung tangentiale Feldkomponente des magnetischen Feldes senkrecht zur Richtung der Rotorachse messen. Mit anderen Worten handelt es sich bevorzugtermassen um einen Aufbau, wie er in der US 4,996,486 beschrieben ist, und entsprechend wird hinsichtlich der grundsätzlichen Bauweise auf dieses Dokument ausdrücklich Bezug genommen und dessen Offenbarungsgehalt mit eingeschlossen. Bei der Durchführung eines derartigen Verfahrens wird bevorzugtermassen die Aufnahmevorrichtung und/oder die Hilfsspule im wesentlichen unmittelbar an der zylindrischen inneren Oberfläche der Stator-Bohrung in axialer und/oder umfangsmässiger Weise entlanggeführt, und aus einer plötzlich auftretenden Änderung der zwei an den verschiedenen Orten gemessenen Signale in relativer Grösse und/oder relativer Phasenlage auf einen Windungsschluss geschlossen, wobei eine entsprechende Auswertung grafisch und/oder automatisiert erfolgen kann. Bevorzugtermassen sind die beiden Detektoren identisch ausgebildet und liegen insbesondere bevorzugt unmittelbar übereinander.

Gemäss einer ersten bevorzugten Ausführungsform des Verfahrens wird zur Differenzbildung das Signal eines der Detektoren als Referenzsignal verwendet.

Zudem erweist es sich als vorteilhaft, wenn zur Auswertung respektive Analyse eine Darstellung der Spulenspannungen in einem Polarkoordinaten-Diagramm in Betrag- und Phasendifferenz verwendet wird, wobei bevorzugtermassen eine Vielzahl von Messpunkten dargestellt respektive analysiert wird.

Die Differenzbildung lässt sich besonders effizient realisieren, da die relative Grösse und/oder die relative Phasenlage der wenigstens zwei Signale über eine Differenzbildung direkt in der Aufnahmevorrichtung ermittelt wird. Konstruktiv besonders zuverlässig ist dies möglich, indem erfindungsgemäss die wenigstens zwei Detektoren in Form von identischen Spulen gleichsinnig in Serie miteinander verbunden werden. Grundsätzlich ist es möglich, die abgegriffene Differenzspannung zunächst aus der elektrischen Maschine herauszuführen und z.B. direkt über einen ADC zu leiten und anschliessend in einem Messcomputer auszuwerten. Da es sich aber bei der Differenzspannung respektive der Differenzphase um ein typischerweise sehr kleines Signal handelt, erweist es sich als vorteilhaft und erfindungsgemäss, wenigstens eine erste Vorverstärkung direkt in der Aufnahmevorrichtung vorzunehmen. Die durch die Serieschaltung erzeugte Differenzspannung wird also durch einen in der Aufnahmevorrichtung angeordneten Verstärker verstärkt.

Die Erfindung ist weiter dadurch gekennzeichnet, dass die Spannung der beiden gleichsinnig in Serie verbundenen Spulen über einen Abgleichwiderstand, welcher bevorzugtermassen elektronisch einstellbar ist, abgegriffen und einem Verstärker zugeführt wird. So ist es möglich, die Differenzbildung optimal einzustellen, das heisst einen gegebenenfalls vorhandenen DC-Offset so weit wie möglich zu vermeiden.

Selbstverständlich ist es möglich, mehr als nur zwei Detektoren übereinander anzuordnen, um eine noch genauere Ausmessung des Gradienten des Magnetfeldes in radialer Richtungen zu ermöglichen. Da genau dieser Gradient für die Bestimmung von Windungsschlüssen entscheidend ist, ist es entsprechend gegebenenfalls bevorzugt, zum Beispiel wenigstens drei Detektoren übereinander anzuordnen, wobei bevorzugtermassen diese mehreren Detektoren jeweils unter Paarbildung gegensinnig in Serie miteinander verbunden sind. Ebenfalls ist es möglich, nicht nur eine Differenzbildung auszuwerten sondern zusätzlich noch das Signal nur eines Detektors, wobei dann gegebenenfalls eine kombinierte Analyse der Differenz und des Signals des einen Detektors vorgenommen werden kann.

Weiterhin betrifft die vorliegende Erfindung eine Vorrichtung zur Durchführung eines Verfahrens, wie es oben beschrieben wurde. Die Vorrichtung ist insbesondere bevorzugt dadurch gekennzeichnet, dass eine Aufnahmevorrichtung mit wenigstens zwei Detektoren angeordnet ist, wobei die Detektoren an zwei verschiedenen radialen Positionen bezüglich der Rotorachse angeordnet sind, und gleichzeitig das magnetische Feld an diesen zwei verschiedenen radialen Positionen bezüglich der Rotorachse messen, und dass eine Auswerteeinheit angeordnet ist, welche die zwei an diesen verschiedenen Orten gemessenen Signale in Grösse und/oder Phasenlage zur Detektion von Windungsschlüsse ausgewertet und/oder miteinander vergleicht, wobei die relative Grösse und/oder die relative Phasenlage der wenigstens zwei Signale über eine Differenzbildung ermittelt wird.

Gemäss einer ersten bevorzugten Ausführungsform ist die Vorrichtung dadurch gekennzeichnet, dass die wenigstens zwei Detektoren im wesentlichen in radialer Richtung bezüglich der Rotorachse übereinander angeordnet sind. Weiterhin ist es bevorzugtermassen möglich, dass die wenigstens zwei Detektoren in Form von bevorzugt identischen Spulen gegensinnig in Serie miteinander verbunden sind und die relative Grösse und/oder die relative Phasenlage der wenigstens zwei Signale über eine Differenzbildung direkt in der Aufnahmevorrichtung ermittelt wird, wobei bevorzugtermassen in der Aufnahmevorrichtung ein Verstärker angeordnet ist, welcher die durch die Serieschaltung erzeugte Differenzspannung verstärkt. In der Aufnahmevorrichtung kann zudem ein bevorzugtermassen elektronisch einstellbarer Abgleichwiderstand angeordnet sein, über welchen die Spannung der beiden gleichsinnig in Serie verbundenen Spulen abgegriffen und einem Verstärker zugeführt wird.

Weitere bevorzugte Ausführungsformen der Erfindung sind in den abhängigen Ansprüchen beschrieben.

### KURZE ERLÄUTERUNG DER FIGUREN

Die Erfindung soll nachfolgend anhand von Ausführungsbeispielen im Zusammenhang mit den Zeichnungen näher erläutert werden. Es zeigen:
- Fig. 1: einen Längsschnitt durch ein Blechpaket, das heisst einen Schnitt axial bezüglich der Rotorachse;
- Fig. 2: einen Querschnitt durch ein Stator-Blechpaket, das heisst einen Schnitt in einer Ebene senkrecht zur Rotorachse;
- Fig. 3: ein Vektordiagramm der in den Detektorspulen induzierten Messspannung für unterschiedliche Situationen;
- Fig. 4: einen Differenz-Feldsensor;
- Fig. 5: einen Differenz-Feldsensor mit Common-Mode Abgleich-Potentiometer;
- Fig. 6: einen Differenz-Feldsensor mit drei Detektorspulen; und
- Fig. 7: einen Differenz-Feldsensor zur Messung des Differenzsignals und des Spulen-Einzelsignals.

### WEGE ZUR AUSFÜHRUNG DER ERFINDUNG

In der Folge soll die Erfindung unter Zuhilfenahme der genannten Figuren an Hand von Ausführungsbeispielen erläutert werden. Die Ausführungsbeispiele dienen zur Illustration der Durchführbarkeit der Erfindung, sie sollen aber nicht dazu verwendet werden, den Schutzumfang, wie er in den angehängten Patentansprüchen definiert wird, in einschränkender Weise auszulegen.

Das neuartige Verfahren zeichnet sich u.a. dadurch aus, dass als Detektor zur Detektion von Windungsschlüssen ein Element verwendet wird, das aus mindestens 2 magnetisch empfindlichen Detektoren S1, S2 besteht, die nahe übereinander, gemessen in senkrechter Richtung zur Blechpaketoberfläche, bzw. nahe übereinander in radialer Richtung der Stator - Bohrung 2, angeordnet sind. Typischerweise handelt es sich um zwei elektrische Spulen, die übereinander angeordnet sind und die so ausgerichtet sind, dass sie primär die tangentiale Feldkomponente quer zur Bohrungsachse messen. Eine derartige Anordnung ist z.B. aus der US 4,996,486 bekannt. Die von diesen Elementen S1, S2 erzeugten Signale, die das jeweils von ihnen gemessene magnetische Feld charakterisieren, werden in Grösse und Phasenlage ausgewertet und miteinander verglichen.

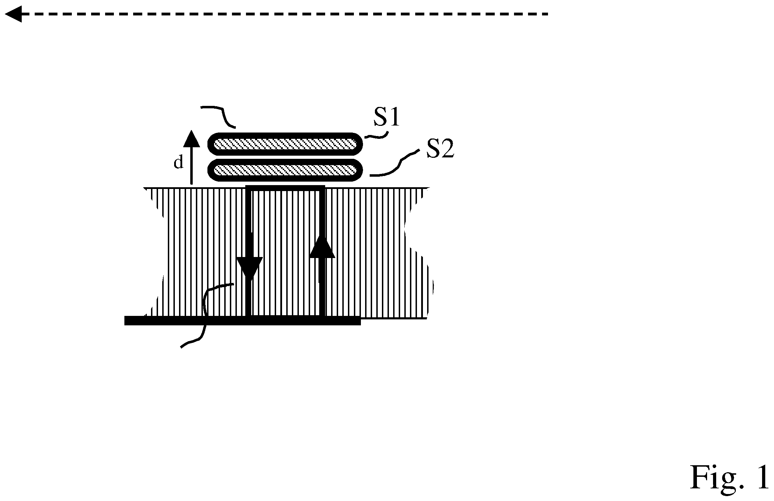

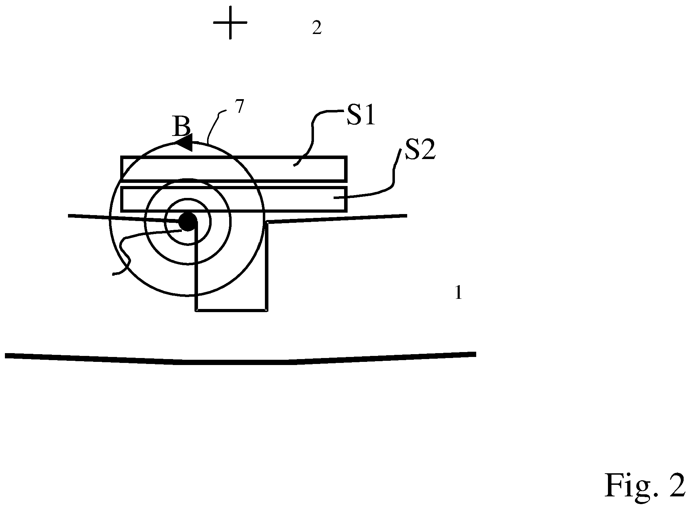

Grundlage des neuen Verfahrens ist nun die Erkenntnis, dass das von einem Blech-Kurzschluss erzeugte magnetische Feld B (vergleiche Figuren 1 und 2) in radialer Richtung zur Rotorachse 3 und nahe der Statorbohrungs-Oberfläche stark inhomogen ist, d.h. dass sich die achsennormale Tangentialkomponente nahe der Oberfläche in radialer Richtung stark ändert. Dies gilt besonders für Blechkurzschlüsse, die sich direkt auf der Oberfläche der Stator-Bohrung befinden, was häufig der Fall ist. Im Gegensatz dazu zeigen Streufelder z.B. des Statorfeldes oder Felder, die nicht von einem lokalen Kurzschluss unmittelbar auf der Statoroberfläche herrühren, eine weitaus homogenere

### Verteilung in radialer Richtung.

Durch Vergleich wird nun ermittelt, ob sich die von den zwei oder mehreren magnetisch empfindlichen Detektoren S1, S2 erzeugten Signale zumindest in der Phasenlage stärker voneinander unterscheiden oder ob sie annähernd gleich sind in Phasenlage und Amplitude. Stärkere Unterschiede werden als Hinweis auf einen Blechkurzschluss gedeutet.

Die starke radiale Ortsabhängigkeit der magnetischen Induktion wird somit zur Identifikation von Blechkurzschlüssen verwendet.

Vorteilhaft wirkt sich bei dieser Methode aus, dass durch geeignete Dimensionierung der einzelnen magnetisch empfindlichen Detektoren oder durch geeignete Signalaufbereitung die Wirkung von homogenen Magnetfeldern annähernd unterdrückt werden kann.

Zur Verdeutlichung sei an einem Beispiel wie in den Figuren 1-3 die generelle Situation illustriert. Figur 1 zeigt einen Stator 1 und seine Bohrung 2 in einem zentralen axialen Schnitt. Figur 1 zeigt zwei übereinanderliegende Detektorspulen S1 und S2 im Querschnitt und das Blechpaket 5 im Längsschnitt (längs der Rotorachse 3), die Blechebene liegt normal zur Bildebene. Figur 2 zeigt die gleiche Anordnung, jedoch als Schnitt quer zur Rotorachse. Ein Kurzschlussstrom 6 ist schematisch angedeutet. Unmittelbar oberhalb der Oberfläche des Blechpaketes 5 ist also die Aufnahmevorrichtung, bestehend aus den beiden Detektorspulen S1 und S2 angeordnet. Der Kurzschlussstrom 6 induziert ein Magnetfeld 7, welches schematisch mit den kreisförmigen Pfeilen in Figur 2 angedeutet und mit dem Bezugszeichen B angegeben ist. Daraus kann erkannt werden, dass die Stärke des Magnetfeldes respektive der magnetische Fluss eine starke Abhängigkeit von der Distanz d des jeweiligen Detektors von der Oberfläche der Stator-Bohrung 2 aufweist.

Aus Figur 2 ist somit ersichtlich,
- dass die beiden Spulen S1 und S2, in Normalrichtung zur Blechpakets-Bohrungsoberfläche gemessen, nahe übereinander angeordnet sind,
- dass das vom Strom 6 durch den Blechkurzschluss erzeugte magnetische Feld 7 eine starke radiale Abhängigkeit aufweist, d.h. dass die Grösse der magnetischen Induktion dieses Feldes 7 stark von der Entfernung von der Bohrungsoberfläche abhängt, wenn sich der Kurzschluss an der Oberfläche befindet.

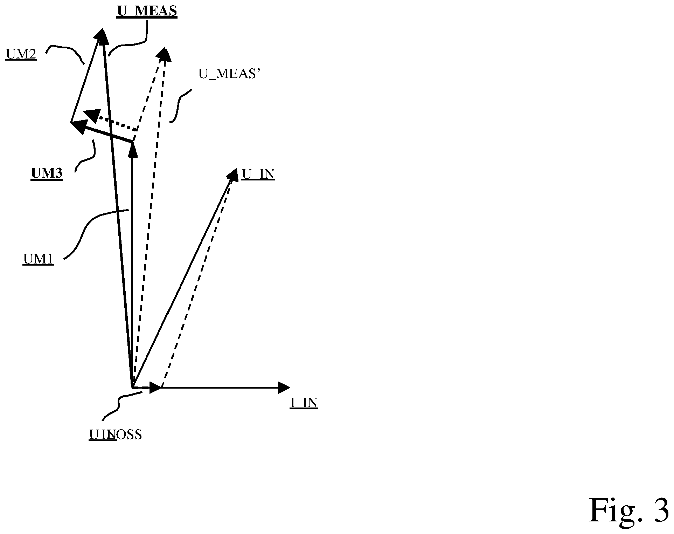

Figur 3 zeigt ein Vektordiagramm der Ströme und Spannungen. Figur 3 zeigt insbesondere die vektorielle Aufteilung der in den Detektorspulen induzierten Messspannung U_MEAS. Diese Spannung kann in drei Hauptkomponenten aufgeteilt werden: Eine Komponente wird direkt vom Erregungsstrom induziert (UM1, Erregerstrom-Spannung), eine andere (UM2, Eisen-Streuspannung) entsteht durch das Streufeld des Stator-Hauptfeldes, die dritte Komponente (UM3, Fehlerstrom-Spannung) wird vom Kurzschlussstrom 6 induziert.

Von diesen Komponenten ist UM3 besonders stark von der Distanz zur Blechoberfläche abhängig, die beiden anderen Komponenten sind unabhängiger von der radialen Höhenposition der Spulen. Mit guter Näherung kann gesagt werden, dass bei gleicher Geometrie der beiden Spulen S1 und S2 (Windungszahl, Querschnitt) hauptsächlich UM3, die vom Kurzschlussstrom erzeugte Spannung, verschieden sein wird.

Anders formuliert bedeutet das, dass die beiden Messpannungen bzw. deren Vektoren annähernd gleich sein werden, wenn unter den Spulen kein Blech-Kurzschluss vorliegt. Wenn die Spulen über einer Fehlerstelle positioniert sind, werden sich beide Vektoren primär in der Komponente UM3 unterscheiden.

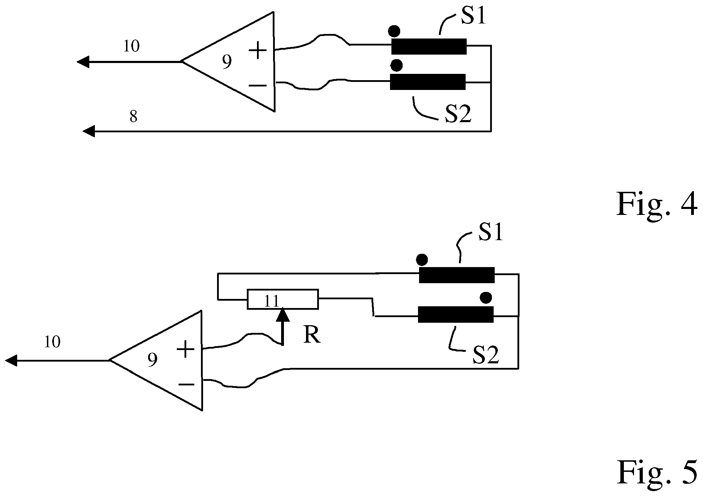

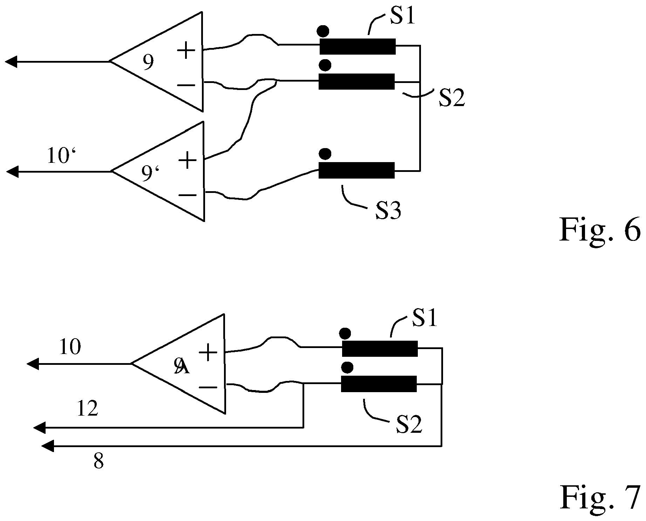

Diese Erkenntnis erlaubt nun folgende Auswerteverfahren bzw. dafür benutzte Vorrichtungen:
- Messung und Auswertung des Phasenwinkels zwischen den Messspannungen der beiden Spulen:
   Eine stärkere, lokal erhöhte Phasendifferenz der beiden Signale deutet auf einen interlaminaren Blechkurzschluss hin. Typischerweise wird für diese Messung das Messsignal der einen Spule als Referenzsignal verwendet. Die Phasenabweichungen des anderen Signals von diesem Referenzsignal werden aufgezeichnet, wobei die beiden Spulen in axialer Richtung entlang der Statorbohrung bewegt werden. Ein etwaiger Phasenwinkel-"Offset" kann an fehlerlosen Stellen leicht als solcher identifiziert werden und somit auch korrigiert werden.
- Darstellung der einen Spulenspannung im Polarkoordinaten - Diagramm in Betrag und Phasendifferenz zur anderen Spulenspannung, wobei wiederum eine Vielzahl von Messpunkten dargestellt wird.
- Eichung der Messvorrichtung mittels einer an der Bohrungsoberfläche angeordneten Leiterschleife und eines durch diese Schleife fliessenden Eichstromes.
- Messung der beiden Spulenspannungen und Subtraktion der Werte: Dazu werden beide Spulenspannungen getrennt gemessen, danach beide Messwerte subtrahiert. Der sich ergebende Differenzwert kann in Phase und Amplitude, wiederum in Abhängigkeit von der axialen Position, aufgezeichnet werden und in einem Polarkoordinaten - Diagramm dargestellt werden. An Fehlerstellen wird ein verstärkter Phasen- und Amplitudenausschlag der Differenzspannung auftreten.
- Direkte Subtraktion der Messwerte im Sensor: Dazu werden gemäss Fig. 4 die beiden identischen Spulen S1, S2 gegensinnig in Serie miteinander verbunden, womit nur Flussdifferenzen eine Ausgangsspannung generieren. Die normalerweise sehr kleine Differenzspannung wird noch durch den Verstärker 9 direkt im Sensor verstärkt. Der Vorteil dieser Anordnung liegt darin, dass Streufelder das schon verstärkte Messsignal weiniger beeinflussen.
- Direkte Subtraktion der Messwerte im Sensor mit Abgleichmöglichkeit: Dazu werden gemäss Fig. 5 die beiden identischen Spulen S1, S2 gleichsinnig in Serie miteinander verbunden und über einen Abgleichwiderstand 11 die Spannung abgegriffen. Die Vorrichtung wird in einem homogenen Feld abgeglichen, sodass nur Flussdifferenzen eine Ausgangsspannung generieren. Die normalerweise sehr kleine Differenzspannung wird noch durch den Verstärker 9 direkt im Sensor verstärkt. Als Abgleichpotentiometer kann z.B. ein elektronisch einstellbares Potentiometer verwendet werden, das z.B. mittels einer seriellen Datenübetragung eingestellt wird.
- Anordnung mit mehreren Detektorspulen, z.B. drei Spulen S1, S2, S3 gemäss Fig. 6: Direkte Subtraktion der Messwerte durch gleichsinnig - serielle Verbindungen und Verstärkung mittels zweier Verstärker 9 und 9'. Diese Konfiguration erlaubt eine noch genauere Ermittlung des Feldgradienten.

### Zusammenfassung

Das Verfahren und die Vorrichtungen zeichnen sich u.a. dadurch aus,
- dass zur Detektion von interlaminaren Blechschlüssen die magnetischen Flussdifferenzen bzw. die Änderungen der Tangentialkomponenten der magnetischen Flüsse in Abhängigkeit von der radialen Höhe nahe der Oberfläche der Statorbohrung gemessen werden;
- dass verstärkte Änderungen der Phasenlage und der Amplitude der magnetischen Flüsse in Abhängigkeit von der radialen Höhe als Hinweis auf einen Blechschluss gewertet werden,
- dass zur Messung der Flussänderungen 2 oder mehrere magnetisch sensitive Detektoren, die hauptsächlich den Tangentialfluss messen, in radialer Richtung übereinander angeordnet sind (Abstand typischerweise im Bereich von 1 - 4 mm),
- dass durch Messung der Phasendifferenz zweier Detektorsignale die Existenz von Blechschlüssen festgestellt wird,
- dass jeweils 2 identische Detektoren elektrisch gegensinnig - seriell verschaltet sind, wobei ein Differenzsignal gebildet wird, welches Flussdifferenzen anzeigt,
- dass jeweils 2 Detektoren über ein einstellbares Widerstandsnetzwerk so verschaltet sind, dass die von homogenen magnetischen Feldern induzierten Spannungen verkleinert werden können,
- dass die Signaldifferenzen direkt am Ort der Detektoren gebildet und mittels Verstärker verstärkt werden.

### BEZUGSZEICHENLISTE

- 1: Stator
- 2: Stator-Bohrung
- 3: Richtung der Rotorachse
- 4: Querschnitte durch Detektor-Spulen
- 5: Blechpaket
- 6: Kurzschlussstrom
- 7: durch Kurzschlussstrom erzeugtes magnetisches Feld
- 8: Erde (GND)
- 9: Verstärker
- 9': weiterer Verstärker für Berücksichtigung der dritten Spule
- 10: Detektorsignal, Differenzsignal
- 10': weiteres Detektorsignal mit dritter Spule, Differenzsignal
- 11: Abgleichwiderstand, Potentiometer
- 12: Detektorsignal einer einzelnen Spule S2

- S1: Detektor, erste Spule
- S2: Detektor, zweite Spule
- S3: Detektor, dritte Spule
- d: Abstand von der Innenfläche der Stator-Bohrung
- B: magnetisches Feld
- U_MEAS: Messpannung mit Blechfehler
- U_MEAS': Messpannung ohne Blechfehler
- UM1: Erregerstrom-Spannung
- UM2: Eisen-Streuspannung
- UM3: Fehlerstrom-Spannung
- I_IN: Erregungsstrom
- U_LOSS: Spannungsverlust, ohmsche Kabelverluste
- U_IN: Eingangs-Erregungsspannung
- R: ohmscher Widerstand, variabel

## Patentansprüche

1. Verfahren zur Detektion von Windungsschlüssen im Blechpaket (5) eines Stators (1) einer elektrischen Maschine oder eines Generators, wobei mittels einer Hilfsspule und eines Hilfsstromes der Stator (1) magnetisiert und mit einer Aufnahmevorrichtung (S1,S2,S3) das magnetische Feld (7, B) ausgemessen wird, wobei die Aufnahmevorrichtung (S1,S2,S3) mittels wenigstens zweier Detektoren (S1,S2,S3), welche an zwei verschiedenen radialen Positionen bezüglich der Rotorachse (3) angeordnet sind, gleichzeitig das magnetische Feld (7, B) an diesen zwei verschiedenen radialen Positionen bezüglich der Rotorachse (3) misst, wobei die zwei an diesen verschiedenen Orten gemessenen Signale (10) in Grösse und/oder Phasenlage zur Detektion von Windungsschlüssen ausgewertet und miteinander verglichen werden,
**dadurch gekennzeichnet, dass**
die relative Grösse und/oder die relative Phasenlage der wenigstens zwei Signale über eine Differenzbildung direkt in der Aufnahmevorrichtung ermittelt wird, indem die wenigstens zwei Detektoren in Form von identischen Spulen (S1,S2,S3) gleichsinnig in Serie miteinander verbunden werden, und nur relative Unterschiede in den Signalen aufgezeichnet werden,
dass die Spannung der beiden gleichsinnig in Serie verbundenen Spulen (S1,S2,S3) über einen Abgleichwiderstand (11), welcher einstellbar ist, abgegriffen und einem in der Aufnahmevorrichtung angeordneten Verstärker (9) zugeführt wird.

2. Verfahren nach Anspruch 1, **dadurch gekennzeichnet, dass** die wenigstens zwei Detektoren (S1,S2,S3) im wesentlichen in radialer Richtung bezüglich der Rotorachse (3) übereinander angeordnet sind.

3. Verfahren nach einem der vorhergehenden Ansprüche, **dadurch gekennzeichnet,**
**dass** es sich bei den Detektoren (S1,S2,S3) um elektrische Spulen handelt, welche so ausgerichtet sind, dass sie primär die bezüglich der zylindrischen inneren Oberfläche der Stator-Bohrung (2) tangentiale Feldkomponente des magnetischen Feldes (7, B) senkrecht zur Richtung der Rotorachse (3) messen.

4. Verfahren nach einem der vorhergehenden Ansprüche, **dadurch gekennzeichnet,**
**dass** die Aufnahmevorrichtung (S1,S2,S3) und/oder die Hilfsspule im wesentlichen unmittelbar an der zylindrischen inneren Oberfläche der Stator-Bohrung (2) in axialer und/oder umfangsmässiger Weise entlanggeführt wird, und dass aus einer plötzlich auftretenden Änderung der zwei an den verschiedenen Orten gemessenen Signale (10) in relativer Grösse und/oder relativer Phasenlage auf einen Windungsschluss geschlossen wird, wobei eine entsprechende Auswertung grafisch und/oder automatisiert erfolgen kann.

5. Verfahren nach einem der vorhergehenden Ansprüche, **dadurch gekennzeichnet,**
**dass** das Signal eines der Detektoren (S1,S2,S3) als Referenzsignal verwendet wird.

6. Verfahren nach einem der vorhergehenden Ansprüche, **dadurch gekennzeichnet,**
**dass** zur Auswertung respektive Analyse eine Darstellung der Spulenspannungen in einem Polarkoordinaten-Diagramm in Betrag- und Phasendifferenz verwendet wird, wobei bevorzugtermassen eine Vielzahl von Messpunkten dargestellt respektive analysiert wird.

7. Verfahren nach einem der Ansprüche 1-6, **dadurch gekennzeichnet, dass** wenigstens drei Detektoren (S1,S2,S3) übereinander angeordnet sind, welche jeweils unter Paarbildung gegensinnig in Serie miteinander verbunden sind.

8. Verfahren nach einem der Ansprüche 1-7, **dadurch gekennzeichnet, dass** zusätzlich gleichzeitig das Signal nur eines Detektors (S1,S2,S3) ausgewertet wird.

9. Vorrichtung zur Durchführung eines Verfahrens nach einem der vorhergehenden Ansprüche, **dadurch gekennzeichnet, dass** eine Aufnahmevorrichtung mit wenigstens zwei Detektoren (S1,S2,S3) in Form von identischen, gleichsinnig in Serie miteinander verbundenenen Spulen (S1,S2,S3) angeordnet ist, wobei die Spulen (S1,S2,S3) an zwei verschiedenen radialen Positionen bezüglich der Rotorachse (3) angeordnet sind, und gleichzeitig das magnetische Feld (7, B) an diesen zwei verschiedenen radialen Positionen bezüglich der Rotorachse (3) messen, und dass eine Auswerteeinheit angeordnet ist, welche die zwei an diesen verschiedenen Orten gemessenen Signale (10) in Grösse und/oder Phasenlage zur Detektion von Windungsschlüsse ausgewertet und/oder miteinander vergleicht, wobei die relative Grösse und/oder die relative Phasenlage der wenigstens zwei Signale über eine Differenzbildung direkt in der Aufnahmevorrichtung ermittelt wird, indem die wenigstens zwei Detektoren in Form von identischen Spulen (S1,S2,S3) gleichsinnig in Serie miteinander verbunden sind, und wobei ein Abgleichwiderstand (11), welcher einstellbar ist, angeordnet ist, welcher die Spannung der beiden gleichsinnig in Serie verbundenen Spulen (S1,S2,S3) abgreift und einem in der Aufnahmevorrichtung angeordneten Verstärker (9), welcher die durch die Serieschaltung erzeugte Differenzspannung verstärkt, zuführt.

10. Vorrichtung nach Anspruch 9, **dadurch gekennzeichnet, dass** die wenigstens zwei Detektoren (S1,S2,S3) im wesentlichen in radialer Richtung bezüglich der Rotorachse (3) übereinander angeordnet sind.

11. Vorrichtung nach Anspruch 9 oder 10, **dadurch gekennzeichnet, dass** in der Aufnahmevorrichtung ein elektronisch einstellbarer Abgleichwiderstand (11) angeordnet ist, über welchen die Spannung der beiden gegensinnig in Serie verbundenen Spulen (S1,S2,S3) abgegriffen und einem Verstärker (9) zugeführt wird.

## Claims

1. Method for detecting turn-to-turn faults in the laminate stack (5) of a stator (1) of an electrical machine or a generator, wherein the stator (1) is magnetized by means of an auxiliary coil and an auxiliary current and the magnetic field (7, B) is measured by a pickup device (S1,S2,S3), wherein the pickup device (S1,S2,S3) simultaneously measures the magnetic field (7, B) at two different radial positions with respect to the rotor axis (3) by means of at least two detectors (S1, S2, S3), which are arranged at these two different radial positions with respect to the rotor axis (3), wherein the two signals (10) measured at these different locations are evaluated and compared with one another in terms of magnitude and/or phase angle for detecting turn-to-turn faults,
**characterized in that**
the relative magnitude and/or the relative phase angle of the at least two signals is determined directly in the pickup device by subtraction by the at least two detectors in the form of identical coils (S1,S2,S3) being connected in series with one another, in the same direction, and only relative differences in the signals are recorded,
**in that** the voltage of the two coils (S1,S2,S3) connected in series in the same direction is tapped off via a trimming resistor (11), which can be adjusted, and is supplied to an amplifier (9) arranged in the pickup device.

2. Method according to Claim 1, **characterized in that** the at least two detectors (S1, S2, S3) are arranged one above the other substantially in the radial direction with respect to the rotor axis (3).

3. Method according to one of the preceding claims,
**characterized in that** the detectors (S1,S2,S3) are electrical coils, which are aligned in such a way that they measure primarily that field component of the magnetic field (7, B) which is tangential to the cylindrical inner surface of the stator bore (2), perpendicular to the direction of the rotor axis (3).

4. Method according to one of the preceding claims,
**characterized in that** the pickup device (S1,S2,S3) and/or the auxiliary coil is guided substantially directly along the cylindrical inner surface of the stator bore (2) in an axial and/or circumferential manner, and **in that** it is concluded from a sudden change in the two signals (10) measured at the various locations in terms of relative magnitude and/or relative phase angle that there is a turn-to-turn fault, with it being possible for corresponding evaluation to be performed graphically and/or in automated fashion.

5. Method according to one of the preceding claims,
**characterized in that** the signal from one of the detectors (S1,S2,S3) is used as reference signal.

6. Method according to one of the preceding claims,
**characterized in that**, for evaluation or analysis purposes, a representation of the coil voltages in a polar coordinate graph in terms of absolute value and phase difference is used, with preferably a large number of measurement points being illustrated or analyzed.

7. Method according to one of Claims 1-6,
**characterized in that** at least three detectors (S1,S2,S3) are arranged one above the other and are connected to one another in series in opposition, in each case so as to form a pair.

8. Method according to either of Claims 1-7,
**characterized in that**, in addition, the signal of only one detector (S1,S2,S3) is evaluated simultaneously.

9. Device for implementing a method according to one of the preceding claims, **characterized in that** a pickup device with at least two detectors (S1,S2,S3) in the form of identical coils (S1,S2,S3) connected in series with one another in the same direction is arranged, wherein the coils (S1,S2,S3) are arranged in two different radial positions with respect to the rotor axis (3) and at the same time measure the magnetic field (7, B) in these two different radial positions with respect to the rotor axis (3), and **in that** there is an evaluation unit which evaluates the two signals (10) measured at these different locations in terms of magnitude and/or phase angle and/or compares said signals with one another for detecting turn-to-turn faults, wherein the relative magnitude and/or the relative phase angle of the at least two signals is determined directly in the pickup device via subtraction by the at least two detectors in the form of identical coils (S1,S2,S3) being connected in series with one another, in the same direction, and wherein a trimming resistor (11), which can be adjusted, is arranged, which resistor taps off the voltage of the two coils (S1,S2,S3) which are connected in series in the same direction and supplies it to an amplifier (9) arranged in the pickup device, said amplifier amplifying the differential voltage generated by the series circuit.

10. Device according to Claim 9, **characterized in that** the at least two detectors (S1,S2,S3) are arranged one above the other substantially in the radial direction with respect to the rotor axis (3).

11. Device according to Claim 9 or 10, **characterized in that** an electronically adjustable trimming resistor (11) is arranged in the pickup device, with the voltage of the two coils (S1,S2,S3), which are connected in series in opposition, being tapped off via said trimming resistor and supplied to an amplifier (9).

## Revendications

1. Procédé de détection de courts-circuits dans l'empilage de tôles (5) d'un stator (1) d'une machine électrique ou d'un générateur, dans lequel le stator (1) est magnétisé au moyen d'une bobine auxiliaire et d'un courant auxiliaire du stator (1) et le champ magnétique (7, B) est mesuré avec un dispositif de prélèvement (S1, S2, S3), dans lequel le dispositif de prélèvement (S1, S2, S3) mesure au moyen d'au moins deux détecteurs (S1, S2, S3), lesquels sont disposés à deux positions différentes radiales par rapport à l'axe de rotor (3), simultanément le champ magnétique (7, B) à ces deux positions radiales différentes par rapport à l'axe de rotor (3), dans lequel les signaux (10) mesurés à ces emplacements différents sont évalués en taille et/ou position de phase pour détecter des courts-circuits et comparés les uns aux autres, **caractérisé en ce que** la taille relative et/ou la position de phase relative des au moins deux signaux est déterminée par une formation de différence directement dans le dispositif de prélèvement, en reliant en série dans le même sens les au moins deux détecteurs sous forme de bobines identiques (S1, S2, S3) et seules les différences relatives dans les signaux sont enregistrées, **en ce que** la tension des deux bobines (S1, S2, S3) reliées en série dans le même sens est prélevée par l'intermédiaire d'une résistance d'équilibrage (11), laquelle peut être réglée, et alimentée dans un amplificateur (9) disposé dans le dispositif de prélèvement.

2. Procédé selon la revendication 1, **caractérisé en ce que** les au moins deux détecteurs (S1, S2, S3) sont disposés l'un au-dessus de l'autre essentiellement dans la direction radiale par rapport à l'axe de rotor (3).

3. Procédé selon une des revendications précédentes, **caractérisé en ce que** les deux détecteurs (S1, S2, S3) consistent en des bobines électriques, lesquelles sont conçues de sorte qu'elles mesurent premièrement des composants de champ tangentiels à la surface intérieure cylindrique de l'alésage de stator (2) du champ magnétique (7, B) perpendiculairement à la direction de l'axe de rotor (3).

4. Procédé selon une des revendications précédentes, **caractérisé en ce que** le dispositif de prélèvement (S1, S2, S3) et/ou la bobine auxiliaire est guidé directement le long de la surface intérieure cylindrique de l'alésage de stator (2) de manière axiale et/ou circonférentielle et **en ce qu'**on conclut d'après une variation se produisant soudainement des deux signaux (10) mesurés à des emplacements différents en taille relative et/ou position de phase relative à un court-circuit, dans lequel une évaluation correspondante peut avoir lieu de manière graphique et/ou automatisée.

5. Procédé selon une des revendications précédentes, **caractérisé en ce que** le signal d'un des détecteurs (S1, S2, S3) est utilisé comme signal de référence.

6. Procédé selon une des revendications précédentes, **caractérisé en ce qu'**à des fins d'évaluation d'analyse respective, une représentation des tensions de bobine dans un diagramme de coordonnées polaires en différence de phase et montant est utilisée, dans lequel de préférence une pluralité de points de mesure est représentée, respectivement analysée.

7. Procédé selon une des revendications 1-6, **caractérisé en ce qu'**au moins trois détecteurs (S1, S2, S3) sont disposés les uns au-dessus des autres, lesquels sont respectivement reliés en série en sens opposé en formant des paires.

8. Procédé selon une des revendication 1-7, **caractérisé en ce qu'**en outre simultanément le signal d'un seul détecteur (S1, S2, S3) est évalué.

9. Dispositif de mise en oeuvre d'un procédé selon une des revendications précédentes, **caractérisé en ce qu'**un dispositif de prélèvement avec au moins deux détecteurs (S1, S2, S3) sous forme de bobines (S1, S2, S3) identiques reliées en série l'une avec l'autre dans le même sens est disposé, dans lequel les bobines (S1, S2, S3) sont disposées à deux positions radiales différentes par rapport à l'axe de rotor (3) et mesurent simultanément le champ magnétique (7, B) à ces deux positions radiales différentes par rapport à l'axe de rotor (3), et **en ce qu'**une unité d'évaluation est disposée, laquelle évalue et/ou compare l'un avec l'autre les deux signaux (10) mesurés à ces emplacements différents en taille et/ou position de phase pour détecter des courts-circuits, dans lequel la taille relative et/ou la position de phase relative des au moins deux signaux est déterminée via une formation de différence directement dans le dispositif de réception, en reliant en série l'un avec l'autre dans le même sens les au moins deux détecteurs sous forme de bobines identiques (S1, S2, S3) et dans lequel une résistance d'équilibrage (11), qui peut être réglée, est disposée, laquelle prélève la tension des deux bobines (S1, S2, S3) reliées en série dans le même sens et alimente dans un amplificateur (9) disposé dans le dispositif de prélèvement, lequel amplifie la tension différentielle générée par le circuit en série.

10. Dispositif selon la revendication 9, **caractérisé en ce qu'**au moins deux détecteurs (S1, S2, S3) sont disposés l'un au-dessus de l'autre essentiellement dans la direction radiale par rapport à l'axe de rotor (3).

11. Dispositif selon la revendication 9 ou 10, **caractérisé en ce qu'**une résistance d'équilibrage (11) réglable électroniquement est disposée dans le dispositif de réception, par l'intermédiaire de laquelle la tension des deux bobines (S1, S2, S3) reliées en série en sens opposé est prélevée et alimentée dans un amplificateur (9).
